# EUROPÄISCHE PATENTSCHRIFT

(11) **EP 3 465 720 B1**
(45) Veröffentlichungstag und Bekanntmachung des Hinweises auf die Patenterteilung: **17.06.2020**
(21) Anmeldenummer: 17725605.4
(22) Anmeldetag: 24.05.2017
(51) Int. Cl.: H01H 47/00, G05B 9/02

(54) **VORRICHTUNG ZUM FEHLERSICHEREN ABSCHALTEN EINES VERBRAUCHERS**
DEVICE FOR FAIL-SAFE DISCONNECTION OF AN ELECTRICAL LOAD
DISPOSITIF DE MISE HORS CIRCUIT SANS ERREUR D'UN CONSOMMATEUR

(30) Priorität: 30.05.2016 DE 102016109915
(43) Veröffentlichungstag der Anmeldung: 10.04.2019
(73) Patentinhaber: Pilz GmbH & Co. KG, 73760 Ostfildern (DE)
(72) Erfinder: MURAVEV, Dmitry, 73760 Ostfildern (DE); DANNENMANN, Klaus Joerg, 73760 Ostfildern (DE)
(74) Vertreter: Witte, Weller & Partner Patentanwälte mbB
(86) Internationale Anmeldenummer: PCT/EP2017/062648
(87) Internationale Veröffentlichungsnummer: WO 2017/207403

(56) Entgegenhaltungen:
- WO-A1-2006/002725
- DE-A1- 10 351 873
- DE-A1-102013 101 932

## Beschreibung

Die vorliegende Erfindung betrifft eine Vorrichtung zum fehlersicheren Abschalten eines externen Verbrauchers mit einem ersten Pol und einem zweiten Pol umfassend eine erste Klemme zum Aufnehmen eines ersten Potentials, eine zweite Klemme zum Aufnehmen eines zweiten Potentials, ein erstes Schaltelement zwischen der ersten Klemme und dem ersten Pol des externen Verbrauchers, ein zweites Schaltelement zwischen der zweiten Klemme und dem zweiten Pol des externen Verbrauchers sowie eine Signalverarbeitungseinheit, die dazu ausgebildet ist, über einen Eingang ein Abschaltsignal aufzunehmen und in Abhängigkeit des Abschaltsignals das erste und das zweite Schaltelement zu betätigen. Die Erfindung betrifft ferner ein entsprechendes Verfahren.

Eine solche Vorrichtung und ein solches Verfahren sind aus der DE 103 51 873 A1 bekannt.

Gattungsgemäße Vorrichtungen werden dazu verwendet, eine technische Anlage bei Auftreten einer Gefahrensituation zuverlässig, das heißt fehlersicher, abzuschalten. Insbesondere sind gattungsgemäße Vorrichtungen dazu geeignet, einen Verbraucher von beiden Polen einer Versorgungsspannung zu trennen. Ein derartiger Anschluss wird in der Fachterminologie auch als zweipoliger Anschluss bezeichnet und gewährleistet, dass auch kapazitive oder induktive Verbraucher, beispielsweise Magnetventile, sicher und zuverlässig abgeschaltet werden können.

Aus der DE 103 51 873 A1 ist bekannt, dass gattungsgemäße Vorrichtungen, um den Anforderungen der einschlägigen Sicherheitsnorm zu genügen, regelmäßig Selbsttests durchführen, in denen sie ihre eigene Funktionsfähigkeit überprüfen. Neben der Feststellung, dass ein Fehler vorliegt, können gattungsgemäße Vorrichtungen auch in beschränktem Umfang angeben, um welche Art von Fehler es sich handelt.

Da bei steigendem Automatisierungsgrad gattungsgemäße Vorrichtungen überwiegend nicht mehr alleine, sondern regelmäßig in einem Verbund eingesetzt werden, kommt der Feststellung, um welche Art von Fehler es sich handelt, immer größere Bedeutung zu. Darüber hinaus führt eine steigende Vernetzung der gattungsgemäßen Vorrichtungen dazu, dass die Vorrichtungen bevorzugt von einer zentralen Stelle aus überwacht und ausgewertet werden. Hierfür ist es erforderlich, dass die Vorrichtungen nicht nur ein sicheres Abschalten einer zu überwachenden Anlage gewährleisten können, wenn ein Fehler vorliegt, sondern dass die Vorrichtungen auch möglichst präzise und detailliert angeben und melden können, um welche Art von Fehler es sich handelt. Insbesondere muss eine Vorrichtung unterscheiden können, ob ein interner Fehler, also ein Fehler der Vorrichtung selbst, oder ein externer Fehler, also beispielsweise ein Verdrahtungsfehler oder ein Lastbruch vorliegt, da je nach Fehlerart die Vorrichtung in einen fehlersicheren Zustand versetzt werden muss.

Es ist daher eine Aufgabe der vorliegenden Erfindung, eine neue Vorrichtung und ein entsprechendes Verfahren eingangs genannter Art anzugeben, bei denen Fehler der Vorrichtung besser und effizienter erkannt werden können. Insbesondere ist es eine Aufgabe der vorliegenden Erfindung, eine Vorrichtung anzugeben, die in einem Selbsttest mehr Fehler als bisherige Vorrichtungen eindeutig bestimmen kann. Ferner ist es eine Aufgabe der vorliegenden Erfindung, eine Vorrichtung anzugeben, die besser zwischen internen und externen Fehlern unterscheiden kann sowie eine zentrale Auswertung und Diagnose ermöglicht.

Gelöst wird diese Aufgabe durch eine Sicherheitsschaltvorrichtung eingangs genannter Art mit einem internen Verbraucher sowie einem dritten Schaltelement, das dazu ausgebildet ist, den internen Verbraucher parallel zu dem externen Verbraucher zu schalten, wobei zwischen dem ersten Schaltelement und dem ersten Pol ein erster Rücklesepunkt angeordnet ist, wobei zwischen dem zweiten Schaltelement und dem zweiten Pol ein zweiter Rücklesepunkt angeordnet ist, wobei zwischen dem dritten Schaltelement und dem internen Verbraucher ein dritter Rücklesepunkt angeordnet ist, wobei die Signalverarbeitungseinheit eine Testeinrichtung und einen Speicher beinhaltet, in dem ein erster Satz von Fehlermustern hinterlegt ist, wobei die Testeinrichtung mit dem ersten, zweiten und dritten Rücklesepunkt gekoppelt ist und dazu ausgebildet ist, einen ersten Schalttest mit mindestens drei voneinander zeitlich getrennten Testintervallen durchzuführen, wobei die Testeinrichtung eingerichtet ist, in jedem Testintervall an dem ersten, zweiten und dritten Rücklesepunkt je ein Rücklesesignal aufzunehmen, um ein erstes Testmuster zu erzeugen, wobei die Testeinrichtung ferner dazu eingerichtet ist, das erste Testmuster mit dem ersten Satz von Fehlermustern abzugleichen, um einen Fehler zu bestimmen.

Die Aufgabe wird ferner gelöst durch ein Verfahren zum fehlersicheren Abschalten eines externen Verbrauchers mit einem ersten Pol, der über ein erstes Schaltelement mit einer ersten Klemme zum Aufnehmen eines ersten Potentials gekoppelt ist, und mit einem zweiten Pol, der über ein zweites Schaltelement mit einer zweiten Klemme zum Aufnehmen eines zweiten Potentials gekoppelt ist, wobei das Verfahren die Schritte umfasst: Aufnehmen eines Abschaltsignals; Betätigen des ersten und des zweiten Schaltelements in Abhängigkeit des Abschaltsignals; Bereitstellen eines internen Verbrauchers sowie Bereitstellen eines dritten Schaltelements, wobei der interne Verbraucher durch Betätigen des dritten Schaltelements zu dem externen Verbraucher parallel schaltbar ist; Bereitstellen eines ersten, zweiten und dritten Rücklesepunkts zwischen dem ersten, zweiten und dritten Schaltelement und dem externen und internen Verbraucher; Bereitstellen eines ersten Satzes von Fehlermustern; Durchführen eines ersten Schalttests mit mindestens drei zeitlich voneinander getrennten Testintervallen; Erzeugen eines ersten Testmusters durch Rücklesen je eines Rücklesesignals an dem ersten, zweiten und dritten Rücklesepunkt in jedem der mindestens drei zeitlich voneinander getrennten Testintervallen; und Bestimmen eines Fehlers durch Abgleichen des ersten Testmusters mit dem ersten Satz von Fehlermustern.

Die neue Vorrichtung verfügt somit über eine Testeinrichtung zum Überprüfen der Vorrichtung auf Fehler. Die Testeinrichtung kann als eine separate Einrichtung, als ein Teil der Signalverarbeitungseinheit oder aber als Softwareimplementierung ausgebildet sein. Die Testeinrichtung kann somit insbesondere auch als ein Steuerprogramm oder ein Teil eines Steuerprogramms ausgebildet sein, welches bei der Signalverarbeitung der an den Eingängen anliegenden Eingangssignale zusätzlich abgearbeitet wird.

Zudem weist die neue Sicherheitsschaltvorrichtung einen internen Verbraucher auf, der über ein weiteres Schaltelement parallel zu dem angeschlossenen externen Verbraucher geschaltet werden kann. Bei dem internen Verbraucher handelt es sich um eine simuliert Last, d.h. um ein elektronisches Bauteil oder eine elektronische Bauteilgruppe, welche die elektrischen Eigenschaften eines gewöhnlichen externen Verbrauchers nachbilden kann. Das dritte Schaltelement ist dazu eingerichtet, die simulierte Last an einem Pol mit dem ersten Pol des Verbrauchers zu verbinden, während der weitere Pol der simulierten Last mit dem zweiten Pol des Verbrauchers verbunden ist.

Die Testeinrichtung ist unabhängig von der gewählten Implementierung dazu ausgebildet, das erste, zweite und dritte Schaltelement zu betätigen, um einen Schalttest durchzuführen. Die Testeinrichtung kann somit das erste, zweite und dritte Schaltelement unabhängig vom anliegenden Abschaltsignal an- und ausschalten.

Über Rücklesepunkte kann die Testeinrichtung eine Reaktion auf die Betätigung des ersten, zweiten und dritten Schaltelements bestimmen, indem an den Rücklesepunkten Rücklesesignale aufgenommen werden. Die Rücklesesignale repräsentieren die jeweilige Spannung an einem Rücklesepunkt, wobei die Spannung durch einen Analog-DigitalWandler in diskrete Werte umgesetzt worden sein kann. Insbesondere kann die Spannung über einen Schwellwertdetektor in zwei Zustände unterteilt werden, sodass das Rücklesesignal ein binäres Signal ist, welches die zwei Zustände repräsentiert.

Erfindungsgemäß wirken die vorstehend genannten Einrichtungen so zusammen, dass in einem ersten Schalttest die Schaltelemente nacheinander in verschiedene Stellungen zueinander gebracht werden, wobei währenddessen über die Rücklesepunkte Rücklesesignale aufgenommen werden. Die Rücklesesignale werden zu einem Testmuster zusammengesetzt und mit den im Speicher hinterlegten Fehlermustern abgeglichen, um einen Fehler eindeutig zu bestimmen.

Mit einem einzigen Schalttest können so auf einfache und effiziente Weise verschiedene Fehler der Vorrichtung identifiziert und eindeutig bestimmt werden. Insbesondere lässt sich ein solcher Schalttest einfach als Teil eines Steuerprogramms realisieren, wodurch eine Testeinrichtung besonders günstig realisiert werden kann. Zudem ist die Testeinrichtung auf einfache Weise erweiterbar, beispielsweise, wenn weitere Fehlermuster identifiziert werden, denen ein eindeutiger Fehler zugeordnet werden kann. Darüber hinaus lassen sich die Schalttests vorteilhaft auf einfache Weise kombinieren, um verschiedene Teststrategien zu implementieren, mit denen weitere Fehler erkannt werden können. Die Verwendung von Testmuster ist somit nicht nur einfacher, sondern auch flexibler, um eine Sicherheitsschaltvorrichtung auf Fehler zu überprüfen und im Fehlerfall eine Diagnose zu erstellen. Folglich kann durch den erfindungsgemäßen Schalttest die Diagnosefähigkeit einer Sicherheitsschaltvorrichtung insgesamt vorteilhaft erhöht werden. Die eingangs genannte Aufgabe ist damit vollständig gelöst.

In einer bevorzugten Ausgestaltung ist die Testeinrichtung eingerichtet, nach jedem der zeitlich voneinander getrennten Testintervalle mindestens eine Schalterstellung des ersten, zweiten oder dritten Schaltelements zu variieren. Durch das Variieren der Schalterstellungen nach jedem Intervall können vorteilhaft alle möglichen Schalterstellungen vollständig permutiert werden, sodass auf einfache Weise ein Testmuster bezüglich aller Schalterstellungen des zumindest ersten und zweiten Schaltelements erzeugt werden kann.

In einer weiteren Ausgestaltung ist jedem Fehlermuster im ersten Satz von Fehlermustern eindeutig eine Fehlerart zugeordnet. Durch die eindeutige Zuordnung von Fehlermustern zu Fehlerarten kann auf einfache Weise aus dem ermittelten Testmuster ein eindeutiger Fehler der Vorrichtung bestimmt werden.

In einer weiteren Ausgestaltung ist das erste Testmuster ein Bitfeld. Ein Bitfeld lässt sich besonders einfach maschinell verarbeiten und mit anderen Bitfeldern vergleichen. Durch einen schnellen Abgleich kann die Dauer eines Test vorteilhaft reduziert werden, wodurch insgesamt die Reaktionszeit der Sicherheitsschaltvorrichtung verringert werden kann.

In einer weiteren Ausgestaltung ist die Testeinrichtung dazu ausgebildet, das erste Testmuster mit einem weiteren Satz von Mustern abzugleichen, um einen fehlerfreien Betrieb zu bestimmen. Die Testeinrichtung ist somit in der Lage auch den "Gutfall", also einen Zustand, in dem die Sicherheitsschaltvorrichtung ordnungsgemäß funktioniert, zu erkennen. Vorzugsweise ist der weitere Satz von Mustern im ersten Satz von Fehlermustern enthalten, um einen schnellen Abgleich zu ermöglichen.

In einer weiteren Ausgestaltung beinhaltet der erste Schalttest vier voneinander getrennte Testintervalle. Bei vier voneinander getrennten Testintervallen können vorteilhaft alle möglichen Schalterstellungen, in denen das erste und zweite Schaltelement zueinander versetzt werden können, jeweils in einem Testlauf getestet werden. So kann ein einziges Testmuster alle Schalterstellungen des ersten und zweiten Schaltelements zueinander wiederspiegeln.

In einer weiteren Ausgestaltung ist die Testeinrichtung eingerichtet, für den ersten Schalttest in einem ersten Intervall weder das erste noch das zweite Schaltelemente zu betätigen, in einem zweiten Intervall nur das erste Schaltelement zu betätigen, in einem dritten Intervall nur das zweite Schaltelement zu betätigen und in einem vierten Intervall das erste und das zweite Schaltelement zu betätigen, wobei nur im vierten Intervall das dritte Schaltelement betätigt ist. Bei diesem Schalttest werden das erste und das zweite Schaltelement in alle möglichen Schalterstellungen zueinander gebracht, wobei der interne Verbraucher nur zugeschaltet wird, wenn das erste und das zweite Schaltelement gleichzeitig betätigt sind. Ein solcher Schalttest ermöglicht es in einem einzigen Testlauf, die Vorrichtungen auf Kurz- und Querschlüsse sowie auf einen Lastbruch hin zu überprüfen. In einem Testlauf können so die gängigsten Fehler einer Sicherheitsschaltvorrichtung mit zweipoligem Anschluss identifiziert werden. Außerdem kann nur bei solch einem Schalttest zusätzlich auch ein "Gutfall" erfasst werden, also der Fall, in dem das Testmuster einen ordnungsgemäßen Betrieb repräsentiert. Dies ist dann der Fall, wenn die Rücklesesignale an den Rücklesepunkten im ersten, zweiten, dritten und vierten Intervall den Erwartungswerten entsprechen.

In einer weiteren Ausgestaltung ist die Testeinrichtung dazu ausgebildet, ein Fehlersignal, welches die Fehlerart repräsentiert, anhand des ersten Schaltests auszugeben, wenn durch den ersten Schalttest ein Fehler eindeutig bestimmt ist. Die Fehlerausgabe erfolgt somit unmittelbar, nachdem ein Fehler erkannt worden ist. Die Fehlerausgabe kann ein Anzeigen oder Melden des Fehlers beinhalten oder aber auch das Ausführen einer Aktion, beispielweise das Auslösen einer Sicherheitsfunktion, umfassen. Es versteht sich, wenn die durch den ersten Schalttest ein "Gutfall" bestimmt worden ist, dass eine entsprechende Ausgabe erfolgt.

In einer weiteren Ausgestaltung ist der erste Schalttest hinsichtlich der Anzahl der voneinander zeitlich getrennten Testintervalle konfigurierbar. Vorteilhaft können die Testintervalle und damit die möglichen Schalterstellungen, die das erste, zweite und dritte Schaltelement zueinander einnehmen können, konfiguriert werden. Insbesondere können bestimmte Schalterstellungen vermieden werden, die im Hinblick auf den angeschlossenen Verbraucher nicht eingenommen werden dürfen. Die Sicherheitsschaltvorrichtung ist durch die Konfigurationsmöglichkeit besonders flexibel für verschiedene externe Verbraucher verwendbar.

In einer weiteren Ausgestaltung ist die Testeinrichtung dazu ausgebildet, einen Funktionstest durchzuführen, der dem ersten Schalttest vorgeschaltet ist. Anhand des Funktionstests kann auf einfache Weise erkannt werden, dass ein Fehler vorliegt und bestimmt werden, ob ein Schalttest zur Identifizierung des Fehlers durchgeführt werden muss, um die Art des Fehlers zu bestimmen. Durch einen nachfolgenden Schalttest kann, wenn in diesem ein "Gutfall" bestimmt wird, das Ergebnis des Funktionstest "überstimmt" werden, d.h. ggf. führt das Entdecken eines Fehlers im Funktionstest nicht zwangsläufig zur Abschaltung der Ausgänge, wenn der nachfolgende Schalttest einen ordnungsgemäßen Betrieb der Vorrichtung anzeigt. Dies kann sich positiv auf die Verfügbarkeit auswirken.

In einer weiteren Ausgestaltung ist die Testeinrichtung eingerichtet, für den Funktionstest nacheinander das erste Schaltelement und das zweite Schaltelement zu betätigen und beim Betätigen des ersten Schaltelements durch Rücklesen am ersten Rücklesepunkt die Funktionsfähigkeit des ersten Schaltelements zu bestimmen, und beim Betätigen des zweiten Schaltelements durch Rücklesen am zweiten Rücklesepunkt die Funktionsfähigkeit des zweiten Schaltelements zu bestimmen. Beim Funktionstest werden somit das erste und das zweite Schaltelement nacheinander betätigt und überprüft. Liegt ein Fehler vor, kann ein Schalttest nachgeschaltet werden. Ein einzelner Funktionstest eines Schaltelements kann sehr schnell ausgeführt werden, wobei das erste und das zweite Schaltelement auch in aufeinanderfolgenden Programmzyklen einer sicheren Steuerung überprüft werden können.

In einer weiteren Ausgestaltung ist die Testeinrichtung dazu eingerichtet, den ersten Schalttest nur dann durchzuführen, wenn in dem Funktionstest ein Fehler bestimmt worden ist. Einen Schalttest erst dann auszuführen, wenn der Funktionstest einen Fehler anzeigt, ist besonders vorteilhaft, da eine Testsequenz zunächst auf den Funktionstest beschränkt werden kann und erst bei Bedarf ein weitergehender Schalttest durchgeführt wird. Auf diese Weise kann die Testdauer eines Tests im Normalfall vorteilhaft sehr kurz sein, sodass die Reaktionszeit der Sicherheitsschaltvorrichtung nur geringfügig durch den Test beeinträchtigt wird.

In einer weiteren Ausgestaltung ist die Testeinrichtung eingerichtet, nach dem ersten Schalttest einen zweiten Schalttest durchzuführen, um ein zweites Testmuster zu erzeugen, wenn nach dem ersten Schalttest kein Fehler eindeutig bestimmt ist. Durch den zweiten Schalttest können vorteilhaft weitere Fehler eindeutig bestimmt werden, falls im ersten Schalttest die Art des Fehlers unbestimmt geblieben ist.

In einer weiteren Ausgestaltung ist die Testeinrichtung eingerichtet, für den zweiten Schalttest in einem ersten Intervall weder das erste noch das zweite Schaltelemente zu betätigen, in einem zweiten Intervall nur das erste Schaltelement zu betätigen, in einem dritten Intervall nur das zweite Schaltelement zu betätigen und in einem vierten Intervall das erste und das zweite Schaltelement zu betätigen, wobei in dem ersten, zweiten, dritten und vierten Intervall das dritte Schaltelement betätigt ist. Bei diesem Schalttest werden das erste und das zweite Schaltelement in alle möglichen Schalterstellungen zueinander gebracht, wobei der interne Verbraucher während der Dauer des Schaltest parallel geschaltet ist. Ein solcher Schalttest ermöglicht es, parallel zu einem Lastbruch die Sicherheitsschaltvorrichtung auf etwaige andere Fehler wie Kurz- und Querschlüsse hin zu überprüfen, wodurch die Diagnosefähigkeit der Sicherheitsschaltvorrichtung weiter vorteilhaft erhöht wird.

In einer weiteren Ausgestaltung ist in dem Speicher ein zweiter Satz von Fehlermustern hinterlegt und die Testeinrichtung ist dazu eingerichtet, das zweite Testmuster mit dem zweiten Satz von Fehlermustern abzugleichen, um einen Fehler eindeutig zu bestimmen. Durch den zweiten Satz von Fehlermustern können vorteilhaft weitere Fehler identifiziert werden. Besonders vorteilhaft ist für jeden Schalttest ein Satz von Fehlermuster hinterlegbar.

In einer weiteren Ausgestaltung ist die Testeinrichtung dazu ausgebildet, ein Fehlersignal, welches die Fehlerart repräsentiert, anhand des zweiten Schalttests auszugeben, wenn durch den ersten Schalttest kein Fehler eindeutig bestimmt worden ist.

In einer weiteren Ausgestaltung repräsentiert die Fehlerart einen internen Hardwarefehler, wenn durch den zweiten Schalttest kein Fehler eindeutig bestimmt ist. Vorteilhafterweise wird somit erst ein interner Hardwarefehler angenommen, wenn durch keinen der vorausgehenden Tests ein Fehler eindeutig identifiziert worden ist. Ein interner Hardwarefehler, bei dem die Sicherheitsschaltvorrichtung in einen Fail-safe-Zustand überführt werden muss, wird somit erst angenommen, wenn alle bekannten Fehler auszuschließen sind.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1:: eine schematische Darstellung eines Ausführungsbeispiels der neuen Vorrichtung,
- Fig. 2:: ein Ablaufdiagramm einer zyklischen Programmbearbeitung einer (sicheren) Steuerung,
- Fig. 3:: eine schematische Darstellung eines Ausführungsbeispiels eines ersten Schalttests,
- Fig. 4:: eine vereinfachte Darstellung eines Ausführungsbeispiels eines ersten Testmusters,
- Fig. 5:: eine schematische Darstellung eines Ausführungsbeispiels eines ersten Satzes an Fehlermustern,
- Fig. 6:: ein Ablaufdiagramm einer bevorzugten Testsequenz, und
- Fig. 7:: eine schematische Darstellung einer bevorzugten Testsequenz.

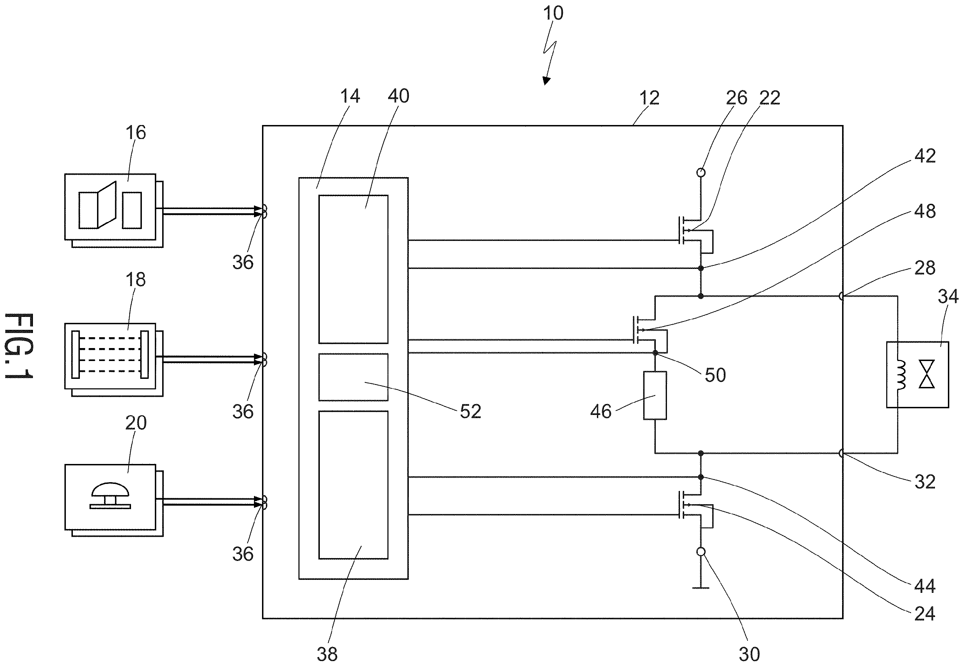

In Fig. 1 ist ein Ausführungsbeispiel der neuen Sicherheitsschaltvorrichtung in seiner Gesamtheit mit der Bezugsziffer 10 bezeichnet. Die Sicherheitsschaltvorrichtung 10 ist hier beispielhaft ein autark funktionsfähiges Sicherheitsschaltgerät, bei dem sämtliche Funktionselemente kompakt in einem Gerätegehäuse 12 eingebaut sind. Alternativ hierzu könnte es sich jedoch beispielsweise auch um eine Baugruppe einer komplexen Sicherheitssteuerung, insbesondere einer für Sicherheitszwecke ausgelegten speicherprogrammierbaren Steuerung (SPS), handeln. In einem weiteren Ausführungsbeispiel (hier nicht gesondert dargestellt) könnte die Sicherheitsschaltvorrichtung 10 mit räumlich verteilten Komponenten aufgebaut sein, die beispielsweise über ein Bussystem miteinander verbunden sind.

Die Sicherheitsschaltvorrichtung 10 besitzt eine Signalverarbeitungseinheit 14. Die Signalverarbeitungseinheit 14 ist hier entsprechend der vorgesehenen Verwendung und der damit verbundenen Sicherheitsanforderung mehrkanalig aufgebaut. Insbesondere weist die Signalverarbeitungseinheit 14 (hier nicht gesondert dargestellt) zwei Mikroprozessoren auf, die miteinander kommunizieren und sich gegenseitig überwachen können.

Eingangsseitig können an die Sicherheitsschaltvorrichtung 10 Signalgeber für Sicherheitszwecke angeschlossen werden. Beispielhaft hierfür sind Schutztüren 16, Lichtschranken 18 und Not-Aus-Schalter 20 dargestellt. Die Signalverarbeitungseinheit 14 wertet die Signale eines oder mehrerer Signalgeber in an sich bekannter Weise fehlersicher aus und steuert in Abhängigkeit davon ein oder mehrere ausgangsseitige Schaltelemente an.

Im vorliegenden Fall besitzt die Sicherheitsschaltvorrichtung 10 zwei ausgangsseitige Schaltelemente 22, 24, die hier als zwei MOS-Transistoren dargestellt sind. Das erste Schaltelement 22 verbindet eine erste Klemme 26, über die der Sicherheitsschaltvorrichtung 10 ein erstes Potential zugeführt werden kann, mit einer ersten Ausgangsklemme 28. Das zweite Schaltelement 24 verbindet eine zweite Klemme 30, über welche die Sicherheitsschaltvorrichtung 10 ein zweites Potential aufnehmen kann, mit einer zweiten Ausgangsklemme 32.

Zwischen der ersten und der zweiten Ausgangsklemme 28, 32 ist ein externer Verbraucher 34 angeschlossen, der von der Sicherheitsschaltvorrichtung 10 in Abhängigkeit der Signale der Signalgeber 16, 18, 20 fehlersicher abgeschaltet werden kann. Bei dem Verbraucher 34 handelt es sich insbesondere um einen induktiven bzw. kapazitiven Verbraucher, wie er hier beispielhaft als Magnetventil dargestellt ist. Derartige Energie speichernde Verbraucher müssen für eine fehlersichere Abschaltung an beiden Polen von einer Versorgungsspannung getrennt werden. In der Fachterminologie wird ein derartiger Anschluss daher auch als ein zweipoliger Anschluss bezeichnet.

Im ordnungsgemäßen Betrieb signalisieren die Signalgeber 16, 18, 20 aktiv einen sicheren Zustand an die Eingänge 36 der Sicherheitsschaltvorrichtung 10. Bei Vorliegen der entsprechenden Eingangssignale betätigt die Signalverarbeitungseinheit 14 das erste und das zweite Schaltelement 22, 24, sodass ein Strompfad von der ersten Klemme 26 über den externen Verbraucher 34 zur zweiten Klemme 30 geschlossen ist. Dabei ist die erste Klemme 26 beispielsweise mit einer Betriebsspannung U_{B} und die zweite Klemme 30 mit einem Masseanschluss verbunden, sodass der externe Verbraucher 34 in etwa der Höhe der Betriebsspannung U_{B} bestromt ist.

Zusätzlich zu den für die Abschaltung wesentlichen Komponenten weist die Sicherheitsschaltvorrichtung 10 Einrichtungen zum Überprüfen dieser Komponenten sowie Einrichtungen zum Durchführen von Selbsttests auf. Insbesondere weist die Sicherheitsschaltvorrichtung 10 eine Testeinrichtung 38 auf, die die entsprechenden Tests durchführt.

Die Testeinrichtung 38 kann wie hier dargestellt eine Komponente der Signalverarbeitungseinheit 14 sein. Alternativ kann die Testeinrichtung 38 auch eine von der Signalverarbeitungseinheit 14 losgelöste eigenständige Einheit sein, beispielsweise ein eigenständiger Mikrocontroller. Darüber hinaus kann die Testeinrichtung 38 in einem anderen Ausführungsbeispiel auch ausschließlich als Softwareimplementierung vorliegen, die auf einem Mikrocontroller 40 der Signalverarbeitungseinheit 14 ausgeführt wird. Die Testeinrichtung 38 ist jedenfalls, unabhängig von ihrer jeweiligen Implementierung, dazu ausgebildet, das erste und das zweite Schaltelement 22, 24 zu betätigen.

Zwischen dem ersten Schaltelement 22 und der ersten Ausgangsklemme 28 befindet sich ein erster Rücklesepunkt, der hier mit der Bezugsziffer 42 bezeichnet ist. Der erste Rücklesepunkt 42 stellt einen Abgriff dar, der mit der Testeinrichtung 38 gekoppelt ist. Über den Abgriff kann die Testeinrichtung 38 die am ersten Rücklesepunkt 42 anliegende Spannung bestimmen. Vorzugsweise weist die Testeinrichtung 38 einen Schwellwertdetektor auf, welcher die am ersten Rücklesepunkt 42 anliegende Spannung in ein binäres Signal wandelt. Alternativ kann die Testeinrichtung 38 auch einen Analog-Digital-Konverter aufweisen, welcher eine an dem ersten Rücklesepunkt 42 anliegende Spannung in diskrete Werte umwandelt.

Ein zweiter Rücklesepunkt, der zwischen dem zweiten Schaltelement 24 und der zweiten Ausgangsklemme 32 angeordnet ist, ist hier mit der Bezugsziffer 44 bezeichnet. Der zweite Rücklesepunkt 44 ist analog zum ersten Rücklesepunkt 42 ausgebildet und ebenfalls mit der Testeinrichtung 38 gekoppelt.

Die Testeinrichtung 38 ist dazu ausgebildet, das erste und das zweite Schaltelement 22, 24 zu betätigen und gleichzeitig an dem ersten und dem zweiten Rücklesepunkt 42, 44 ein Rücklesesignal, vorzugsweise ein binäres Signal, zu bestimmen. Aus den Rücklesesignalen kann, wie nachfolgend noch näher erläutert, ein Testmuster generiert werden.

Darüber hinaus weist die Sicherheitsschaltvorrichtung einen internen Verbraucher 46 sowie ein drittes Schaltelement 48 auf.

Der interne Verbraucher 46 ist dazu ausgebildet, einen externen Verbraucher 34 zu simulieren. Mit anderen Worten ist der interne Verbraucher 46 ein elektronisches Bauteil, welches die gleichen oder ähnliche elektrische Eigenschaften aufweist wie ein bevorzugter externer Verbraucher 34. Der interne Verbraucher 46 kann beispielsweise ein einfacher elektrischer Widerstand sein. Alternativ oder ergänzend kann der interne Verbraucher 46 auch weitere elektronische Bauteile wie Spulen oder Kondensatoren aufweisen, um die elektrischen Merkmale eines externen Verbrauchers 34 nachzubilden.

Der Begriff "intern" bedeutet hier, dass der Verbraucher eine Komponente der Sicherheitsschaltvorrichtung ist. Daraus folgt nicht zwangsläufig, dass der interne Verbraucher, wie hier dargestellt, fest im Gehäuse 12 der Sicherheitsschaltvorrichtung 10 integriert sein muss. Alternativ können an der Sicherheitsschaltvorrichtung 10 auch nur Anschlussklemmen vorgesehen sein, mit denen ein "interner" Verbraucher extern bereitgestellt werden kann. Dies hätte den Vorteil, dass der interne Verbraucher an einen zu erwartenden externen Verbraucher angepasst werden kann. In einem weiteren Ausführungsbeispiel kann der interne Verbraucher auch variabel eingerichtet sein, sodass die Testeinrichtung 38 die elektrischen Eigenschaften des internen Verbrauchers ändern und nach Bedarf anpassen kann.

Unabhängig von der Ausgestaltung des internen Verbrauchers 46 ist dieser über das dritte Schaltelement 48 parallel zum externen Verbraucher 34 schaltbar, d.h. das dritte Schaltelement 48 und der interne Verbraucher 46 sind in Serie geschaltet zwischen der ersten Ausgangsklemme 28 und der zweiten Ausgangsklemme 32 angeordnet. Zwischen dem dritten Schaltelement 48 und dem internen Verbraucher 46 ist ein dritter Rücklesepunkt angeordnet, der hier mit der Bezugsziffer 50 bezeichnet ist. Wie an den zuvor beschriebenen ersten und zweiten Rücklesepunkten 42, 44 kann auch am dritten Rücklesepunkt 50 eine Spannung bzw. ein definierter Zustand durch die Testeinrichtung 38 bestimmt werden.

Darüber hinaus weist die Sicherheitsschaltvorrichtung 10 einen Speicher 52 auf. Im vorliegenden Fall ist der Speicher 52 in der Signalverarbeitungseinheit 14 integriert. Alternativ kann der Speicher 52 aber auch ein eigenständiges Bauteil sein, auf welches die Testeinrichtung 38 zugreifen kann. Im Speicher 52 sind Werte und Zuordnungstabellen hinterlegbar, die von der Testeinrichtung 38 abgefragt werden können. Insbesondere sind im Speicher 52 Fehlermuster hinterlegt, die jeweils einem Fehler eindeutig zugeordnet sind.

Zum Testen der Sicherheitsschaltvorrichtung 10 durch die Testeinrichtung 38 wird vereinfacht dargestellt, das erste, zweite und dritte Schaltelement 22, 24, 48 betätigt und an dem ersten, zweiten und dritten Rücklesepunkt 42, 44, 50 je ein Rücklesesignal zurückgelesen. Aus den Rücklesesignalen wird anschließend ein Testmuster generiert und mit den im Speicher 52 hinterlegten Fehlermustern abgeglichen. Aus dem Abgleich kann die Funktionsfähigkeit der Sicherheitsschaltvorrichtung 10 bestimmt werden sowie im Fehlerfall die Fehlerart.

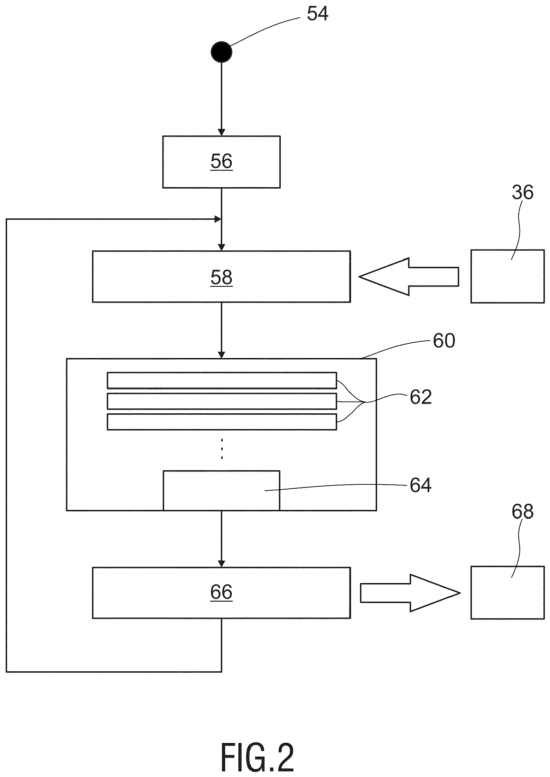

Eine einfache sowie eine bevorzugte Teststrategie werden im Folgenden anhand der Fig. 2 bis 7 näher erläutert.

Fig. 2 zeigt in einem vereinfachten Diagramm einen zyklischen Programmablauf einer (sicheren) Steuerung. Eine sichere Steuerung kann dabei eine oder mehrere Sicherheitsschaltvorrichtungen 10 im Sinne der vorliegenden Offenbarung oder weitere andere Sicherheitsschaltgeräte umfassen.

Grundsätzlich arbeitet eine hier beschriebene sichere Steuerung wie eine normale Steuerung nach dem EVA-Prinzip (Eingabe-Verarbeitung-Ausgabe). Nach einem ersten Neustart 54 werden zunächst alle Ausgänge, Zeitglieder, Zähler und Merker auf null gesetzt, wie hier mit der Bezugsziffer 56 angedeutet. Nach dem Reset 56 wird im Schritt 58 ein Prozessabbild der Eingänge (PAE) aufgenommen, das die Eingangssignale, die an den Eingängen 36 von den Meldegeräten 16, 18, 20 bereitgestellt werden, wiederspiegelt. Das PAE wird mit den aktuellen Signalzuständen zur weiteren Verarbeitung in einem besonderen Speicher der Steuerung abgelegt.

Nach dem Einlesen des PAE folgt die Abarbeitung eines im Speicher hinterlegten Steuerprogramms, wie hier mit Schritt 60 angedeutet. Das Steuerprogramm umfasst eine Vielzahl von Anweisungen 62, die sequenziell, also Anweisung für Anweisung, abgearbeitet werden. Beim Abarbeiten der Anweisungen greift die Steuerung nicht mehr direkt auf die Eingänge selbst zu, sondern nur noch auf das im Speicher liegende PAE. Sollen im Laufe des Programms Ausgänge verändert werden, erfolgt dies zunächst in einem besonderen Speicherbereich, dem sog. Prozessabbild der Ausgänge (PAA). Erst wenn das Steuerprogramm vollständig abgearbeitet worden ist, wird das PAA auf die tatsächlichen Ausgänge übertragen.

Das Steuerprogramm umfasst hier zusätzlich ein Testprogramm 64. Das Testprogramm 64 kann das Steuerprogramm lediglich um weitere Anweisungen 62 erweitern oder aber als eine eigenständige Softwarekomponente ausgebildet sein, die nach der letzten Anweisung 62 des Steuerprogramms ausgeführt wird. Unabhängig von der jeweiligen Realisierung ist das Testprogramm 64 dazu ausgebildet mit den zuvor beschriebenen Einrichtungen zum Testen innerhalb der Sicherheitsschaltvorrichtung 10 zusammenwirken, um Tests durchzuführen und entsprechende Testergebnisse zu generieren und bereitzustellen. Es versteht sich, dass das Testprogramm 64 als Teil des Steuerprogramms Ausgänge über das PAA direkt ansteuern kann bzw. über Änderungen an dem PAE Anweisungen an das Steuerprogramm übergegen kann, die im nächsten Programmzyklus berücksichtigt werden. Das Testprogramm 64 muss nicht innerhalb eines Programmzyklus vollständig abgeschlossen werden. Vielmehr kann ein einmal gestartetes Testprogramm 64 auch selbstständig mehrere Programmzyklen überdauern.

Nach der letzten Anweisung 62 werden die Zustände aus dem PAA an die eigentlichen Ausgänge 68 weitergegeben. Dies geschieht im Schritt 66. Anschließend wiederholt sich der Vorgang ab Schritt 58 und die Eingänge 36 werden erneut in das PAE eingelesen.

Ändert sich der Signalzustand eines Eingangs während eines Programmzyklus, so wird dies erst bemerkt, wenn das nächste Mal das PAE gebildet wird. Dadurch entstehen bei der Steuerung Reaktionszeiten, die im ungünstigsten Fall zweimal so lang wie die Zykluszeit sein können. Die Zykluszeit ist abhängig von der Länge des Steuerprogramms kann beispielsweise 8 Millisekunden je 1000 Anweisungen 62 dauern. Die Abarbeitung des Testprogramms kann mehrere PAE und PAA Zyklen dauern und muss nicht zwangsläufig zwischen einem PAE und einem darauffolgenden PAA erfolgen.

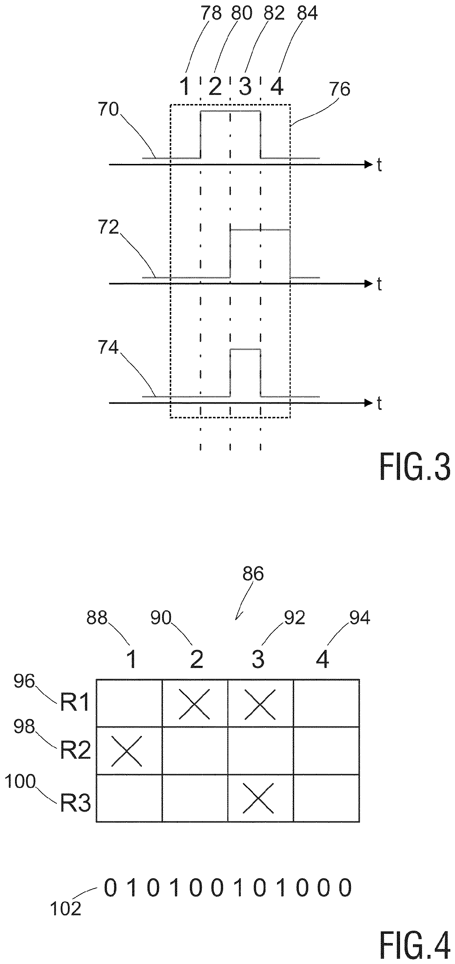

Mit Bezug auf Fig. 3 wird im Folgenden ein erster Schalttest, wie er von der Testeinrichtung 38 durchgeführt wird, näher erläutert.

In der Fig. 3 sind die jeweiligen Schaltzustände des ersten, zweiten und dritten Schaltelements 22, 24, 48 über die Zeit t dargestellt. Das obere Diagramm mit der Bezugsziffer 70 repräsentiert die Schalterstellung des ersten Schaltelements 22, das mittlere Diagramm mit der Bezugsziffer 72 repräsentiert die Schalterstellung des zweiten Schaltelements 24 und das dritte Diagramm mit der Bezugsziffer 74 repräsentiert die Schalterstellung des dritten Schaltelements 48. Wie dem ersten, zweiten und dritten Diagramm 70, 72, 74 zu entnehmen ist, kann ein Schaltelement 22, 24, 48 einen betätigten bzw. einen nicht betätigten Zustand einnehmen. Eine definierte Testperiode 76 ist hier in vier gleich lange nicht überlappende Testintervalle 78, 80, 82, 84 unterteilt. Die Einteilung der Testperiode 76 in vier Testintervalle 78, 80, 82, 84 ist bevorzugt. Im Sinne der vorliegenden Offenbarung kann ein erster Schalttest aber auch nur drei Testintervalle umfassen.

Im vorliegenden Fall sind im ersten Testintervall 78 weder das erste Schaltelement 22, das zweite Schaltelement 24 noch das dritte Schaltelement 48 betätigt. Im zweiten Testintervall 80 ist das erste Schaltelement 22 betätigt, während das zweite Schaltelement 24 und das dritte Schaltelement 48 nicht betätigt sind. Im dritten Testintervall 82 sind das erste Schaltelement 22 und das zweite Schaltelement 24 betätigt sowie das dritte Schaltelement 48. Im vierten Testintervall 84 ist das zweite Schaltelement 24 betätigt, während das erste Schaltelement 22 und das dritte Schaltelement 48 nicht betätigt sind.

Die erste Testperiode 76 stellt den bevorzugten Verlauf eines ersten Schalttests im Sinne der vorliegenden Offenbarung dar. In dem bevorzugten ersten Schalttest werden somit innerhalb des ersten bis vierten Testintervalls die Schalterstellung des ersten und zweiten Schaltelements 22, 24 vollständig permutiert, während das dritte Schaltelement 48 nur betätigt wird, wenn sowohl das erste Schaltelement 22 als auch das zweite Schaltelement 24 betätigt sind. Es versteht sich, dass die hier dargestellte Reihenfolge der Testintervalle 78, 80, 82, 84 nur exemplarisch ist. Vielmehr ist die Reihenfolge der Testintervalle 78, 80, 82, 84 beliebig.

In jedem Testintervall 78, 80, 82, 84 wird unmittelbar, oder bevorzugt alle 100us, der jeweilige Zustand an dem ersten, zweiten und dritten Rücklesepunkt 42, 44, 50 bestimmt und im Speicher 52 hinterlegt. Nach Ablauf des vierten Testintervalls 84 werden die in den jeweiligen Testintervallen zurückgelesenen Zustände an dem ersten, zweiten und dritten Rücklesepunkt 42, 44, 50 zu einem ersten Testmuster 86 zusammengeführt, wie es mit Bezug auf die Fig. 4 näher erläutert ist.

Fig. 4 zeigt eine schematische Darstellung eines Ausführungsbeispiels eines ersten Testmusters 86. Das Testmuster 86 ist hier matrixartig dargestellt, wobei die Spalten 88, 90, 92, 94 dem ersten, zweiten, dritten und vierten Testintervall 78, 80, 82, 84 entsprechen. Die Spalten 88, 90, 92, 94 entsprechen einem 3-Tupel, in dem die jeweiligen Zustände an dem ersten, zweiten und dritten Rücklesepunkt während des entsprechenden Testintervalls abgelegt sind.

Die Zustände an dem ersten, zweiten und dritten Rücklesepunkt 42, 44, 50 sind im vorliegenden Ausführungsbeispiel als binäre Zustände erfasst, d.h. es wird zwischen einem ersten und einem zweiten Zustand an dem jeweiligen Rücklesepunkt unterschieden. Der erste Zustand wird in Fig. 4 durch ein Kreuz in dem entsprechenden Feld dargestellt, während der zweite Zustand durch ein leeres Feld repräsentiert wird. Die Zeilen 96, 98, 100 repräsentieren den ersten, den zweiten und den dritten Rücklesepunkt 42, 44, 50. In der ersten Zeile 96 sind somit die am ersten Rücklesepunkt 42 zurückgelesenen Zustände in den jeweiligen Testintervallen 78, 80, 82, 84 dargestellt. Die zweite Zeile 98 repräsentiert die entsprechenden Zustände am zweiten Rücklesepunkt 44 und die dritte Zeile 100 repräsentiert die Zustände am dritten Rücklesepunkt 50 während der jeweiligen Testintervalle. Handelt es sich bei den Rücklesesignalen an dem ersten, zweiten und dritten Rücklesepunkt 42, 44, 50 um binäre Zustände, kann das Testmuster 86 besonders einfach als Bitfeld dargestellt werden. Ein Bitfeld, welches das in der Tabelle dargestellte Testmuster repräsentiert, ist hier mit der Bezugsziffer 102 angedeutet. Jedes Bit der Bitfolge repräsentiert einen Zustand an einem Rücklesepunkt während eines Testintervalls. Wie zuvor angedeutet, können die Testintervalle auch in einer anderen als der hier dargestellten Reihenfolge durchgeführt werden. Die Reihenfolge der Zustände im Testmuster ändert sich dann entsprechend.

Es versteht sich, dass in anderen Ausführungsbeispielen die Rücklesesignale am ersten, zweiten und dritten Rücklesepunkt 42, 44, 50 auch mehr als zwei Zustände einnehmen können. Das Testmuster 86 wäre dann aus einer sortierten Folge von Symbolen zusammengesetzt, die die einzelnen Zustände repräsentieren. Die verschiedenen Symbole, die die unterschiedlichen Zustände darstellen, können wiederum im Binärsystem dargestellt werden, wobei sich in diesem Fall das Bitfeld 102 lediglich verlängern würde.

Sobald ein erstes Testmuster 86 nach Ablauf der ersten Testperiode 76 erstellt worden ist, gleicht die Testeinrichtung 38 das erste Testmuster 86 mit einem ersten Satz von Fehlermustern ab, um einen Fehler der Sicherheitsschaltvorrichtung 10 zu bestimmen. Mit anderen Worten sucht die Testeinrichtung in einer Tabelle mit Fehlermustern nach einem Muster, welches dem Testmuster entspricht, wobei jedes Fehlermuster eindeutig mit einem Fehler verknüpft ist. Kann für ein Testmuster kein Fehlermuster gefunden werden, ist der Fehler unbestimmt, dass heißt dem Testmuster kann kein bekannter Fehler zugeordnet werden.

Ebenso ist es möglich, dass der Satz von Fehlermustern auch ein oder mehrerer Muster enthält, die einen sogenannten "Gutfall" repräsentieren. Als "Gutfall" wird ein Testmuster bezeichnet, welches einen fehlerfreien Zustand des Sicherheitsschaltgeräts repräsentiert, also den Zustand, in dem positiv erkannt wird, dass das erste und zweite Schaltelement fehlerfrei arbeiten und kein interner Fehler vorliegt. Vorzugsweise kann bei einem "Gutfall" ein interner sowie ein externer Fehler ausgeschlossen werden.

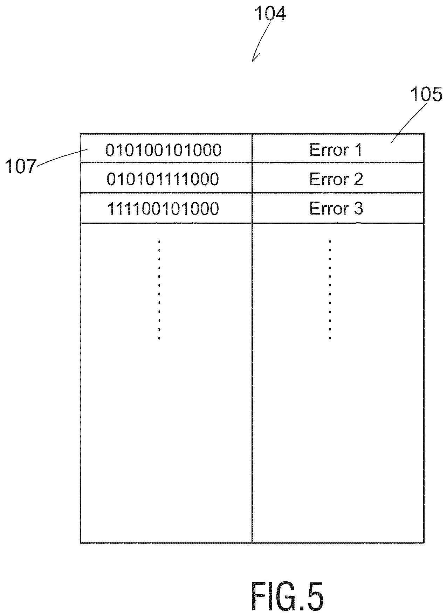

Fig. 5 zeigt exemplarisch einen ersten Satz von Fehlermustern 104. Im Wesentlichen entspricht der erste Satz von Fehlermustern einer Zuordnungstabelle, die im Speicher 52 abgelegt ist. In der Tabelle ist jedem bekannten Fehlermuster ein entsprechender Fehler zugeordnet. Vorzugsweise ist für jeden Schalttest im Sinne der vorliegenden Offenbarung ein eigener Satz von Fehlermustern verfügbar.

Die Testeinrichtung 38 ist dazu ausgebildet, das in der ersten Testperiode 76 bestimmte Testmuster 86 im ersten Satz von Fehlermustern 104 zu identifizieren und, sofern vorhanden, einen entsprechenden Fehler 105 anzuzeigen bzw. eine dem Fehler entsprechende Maßnahme auszulösen.

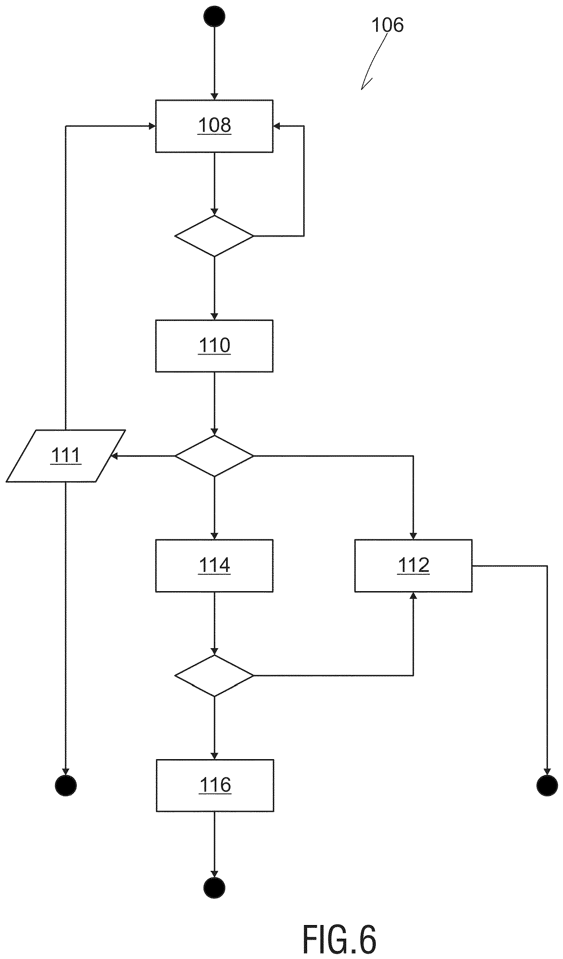

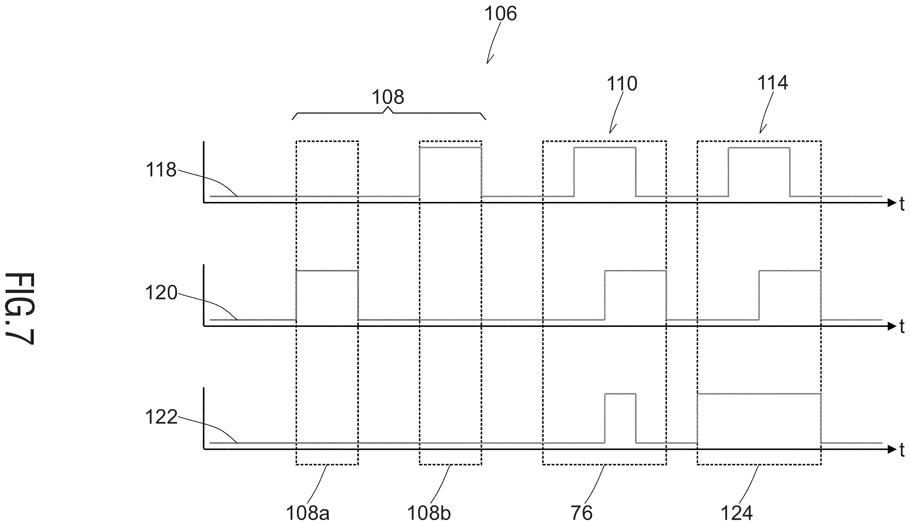

Der erste Satz von Fehlermustern 104 kann dabei unterbestimmt, d.h. nicht alle möglichen Muster 107 sind in dem Satz von Fehlermustern 104 hinterlegt, sondern nur diejenigen Muster, denen ein eindeutiger Fehler zugeordnet werden kann. Ist ein Fehlermuster 86 im ersten Satz von Fehlermustern 104 nicht aufgeführt, kann kein eindeutiger Fehler bestimmt werden. In diesem Fall wird vorzugsweise ein zweiter Schalttest durchgeführt, bei dem innerhalb einer zweiten Testperiode das erste, das zweite und das dritte Schaltelement 22, 24, 48 in unterschiedliche Stellung zueinander gebracht werden, sodass ein zweites Testmuster bestimmt werden kann, welches wiederum mit einem zweiten Satz von Fehlermustern abgeglichen wird. Eine derart bevorzugte Teststrategie wird mit Bezug auf die Fig. 6 und 7 näher erläutert.

Fig. 6 zeigt ein Ablaufdiagramm einer bevorzugten Testsequenz 106.

Bei der bevorzugten Testsequenz 106 wird zunächst ein Funktionstest 108 durchgeführt, um die Funktionsfähigkeit des ersten und zweiten Schaltelements 22, 24 zu testen.

Beim Funktionstest 108 werden das erste und das zweite Schaltelement 22, 24 auf ihre Funktionsfähigkeit hin überprüft, indem die Testeinrichtung 38 abwechselnd das erste und das zweite Schaltelement 22, 24 betätigt. Beim Funktionstest 108 wird vorzugsweise kein vollständiges Testmuster im Sinne dieser Offenbarung erzeugt, sondern unmittelbar nach dem Betätigen des ersten bzw. des zweiten Schaltelements 22, 24 an dem entsprechenden ersten bzw. zweiten Rücklesepunkt 42, 44 ein Rücklesesignal abgegriffen und direkt mit einem Erwartungswert verglichen.

Der Funktionstest wird unabhängig vom aktuellen Stand der Schaltelemente 22, 24 bzw. des Prozessabbilds der Ausgänge durchgeführt. Vorzugsweise wird der Funktionstest 108 in jedem des in Fig. 2 beschriebenen Programmzyklus einmal ausgeführt. Besonders bevorzugt wird in jedem Zyklus jeweils nur das erste oder das zweite Schaltelement 22, 24 getestet und das jeweils andere in dem darauf folgenden Zyklus. Alternativ können in einem Zyklus auch das erste und das zweite Schaltelement 22, 24 nacheinander getestet werden. Das Ausführen der Schalttests 110, 114 kann auch mehrere Programmzyklen dauern. Somit muss nicht nach jedem Programmzyklus ein Ergebnis der Schalttests vorliegen.

Für jede Schalterstellung des ersten bzw. des zweiten Schaltelements 22, 24 gibt es beim Funktionstest eine definierte Erwartungshaltung an die Rücklesesignale, die am ersten Rücklesepunkt und am zweiten Rücklesepunkt 42, 44 abgegriffen werden. Entsprechen die Rücklesesignale den definierten Erwartungshaltungen, wird die Testsequenz 106 beendet und der zyklische Programmablauf gemäß Fig. 2 fortgesetzt, d.h in einem nächsten Zyklus wird erneut der Funktionstest 108 ausgeführt.

Entsprechen die Rücklesesignale nicht den Erwartungshaltungen, liegt ein Fehler vor, wobei aus dem Funktionstest 108 selbst die Art des Fehlers nicht bestimmt werden kann. Liegt ein Fehler vor, wird als Nächstes ein erster Schalttest 110 durchgeführt, wobei der erste Schalttest 110 einem ersten Schalttest, wie er in Bezug auf die Fig. 3 erläutert worden ist, entspricht.

Im ersten Schalttest 110 werden alle möglichen Kombinationen an Schalterstellungen des ersten und des zweiten Schaltelements 22, 24 getestet. Der interne Verbraucher 46 wird jedoch nur zeitweise zugeschaltet. Zu jeder Kombination existiert eine Erwartungshaltung an die Rücklesesignale an dem ersten, zweiten und dritten Rücklesepunkt 42, 44, 50. Aus den Rücklesesignalen wird im Anschluss an die erste Testperiode 76 ein Testmuster 86, wie in Bezug auf die Fig. 4 erläutert, erzeugt und mit einem ersten Satz von Fehlermustern 104 abgeglichen, um einen eindeutigen Fehler 105 zu bestimmen. Falls sich für das Testmuster ein eindeutiger Fehler bestimmen lässt, wird der Fehler im Schritt 112 ausgegeben

Ebenso kann das Testmuster 86 einem "Gutfall" entsprechen. Dann liegen weder externe noch interne Fehler vor. In diesem Fall kann je nach Konfiguration 111 das bisherige Ergebnis des Funktionstest ignoriert werden oder aber bevorzugt der Funktionstest 108 erneut durchgeführt werden.

Neben der Fehlerausgabe 112 und Signalisierung des erkannten Fehlers können auch weitere Maßnahmen unmittelbar ergriffen werden. Beispielsweise kann die Fehlerausgabe 112 unmittelbar Einfluss auf das PAA nehmen bzw. über das Setzen eines Bits im PAE den entsprechenden Fehler an das Steuerprogramm der Sicherheitssteuerung übergeben. Entspricht beispielsweise der im ersten Schalttest 110 bestimmte Fehler einem Lastbruch, d.h. einem Zustand, in dem der externe Verbraucher 34 von der Sicherheitsschaltvorrichtung 10 getrennt worden ist, so kann dieser Zustand an die sichere Steuerung gemeldet werden, ohne dass das Sicherheitsschaltgerät 10 selbst in einen sicheren Zustand übergehen muss. Dies ist besonders vorteilhaft, da so eine bessere Verfügbarkeit gewährleistet werden kann, da ein externer Fehler nicht unmittelbar dazu führt, dass eine Fail-safe-Zustand 116 eingenommen werden muss und die Sicherheitsschaltvorrichtung bis auf weiteres blockiert ist.

Wird beim ersten Schalttest 110 kein Fehler oder der "Gutfall" eindeutig bestimmt, folgt bei dieser bevorzugten Teststrategie keine Fehlerausgabe 112, sondern zunächst ein zweiter Schalttest 114. Beim zweiten Schalttest 114 wird ein zweites Testmuster erzeugt, indem das erste, zweite und dritte Schaltelement 22, 24, 48 in mindestens drei Testintervallen in verschiedene Schalterstellungen gebracht werden, und Rücklesesignale während dieser Testintervalle am ersten, zweiten und dritten Rücklesepunkt 42, 44, 50 abgegriffen werden. Das zweite Testmuster wird anschließend mit einem zweiten Satz an Fehlermustern abgeglichen, um einen eindeutigen Fehler zu identifizieren. Kann ein Fehler eindeutig identifiziert werden, erfolgt die zuvor beschriebene Fehlerausgabe gemäß Schritt 112.

Falls dem zweiten Testmuster kein eindeutiger Fehler zugeordnet werden kann, wird ein interner Defekt angenommen und die Sicherheitsschaltvorrichtung 10 im Schritt 116 in einen Fail-safe-Zustand überführt. Dies bedeutet im Regelfall, dass die sichere Steuerung in einen sicheren Modus übergeht, in dem für eine Person oder Gegenstände im Bereich einer zu überwachenden Anlage keine Gefahr mehr ausgeht. Üblicherweise beinhaltet dies das Abschalten sämtlicher Ausgänge 68 der sicheren Steuerung.

Vorzugsweise ist auch der zweite Schalttest 114 in vier zeitlich voneinander getrennte Intervalle unterteilt, in denen das erste und das zweite Schaltelement 22, 24 alle möglichen Schalterstellungen in Bezug zueinander einnehmen, während das dritte Schaltelement 48 kontinuierlich betätigt ist. Wie beim ersten Schalttest 110 werden somit alle Schalterstellungen vollständig permutiert, wobei der interne Verbraucher 46 kontinuierlich zu den Ausgangsklemmen 28, 32 parallel geschaltet ist. Mit dem zweiten Schalttest 114 kann im Falle eines Lastbruchs zusätzlich erkannt werden, ob ein Kurz- oder Querschluss vorliegt. Durch den zweiten Schalttest 114 wird somit insbesondere die Diagnosefähigkeit der Sicherheitsschaltvorrichtung vorteilhaft erhöht, da Fehler noch besser differenziert werden können.

Mit Bezug auf Fig. 7 werden im Folgenden die Schalterstellungen des ersten, zweiten und dritten Schaltelements 22, 24, 48 während der bevorzugten Testsequenz 106 näher erläutert. In der Fig. 7 sind die Schalterstellungen des ersten, zweiten und dritten Schaltelements 22, 24, 48 über die Zeit t aufgetragen. Das obere Diagramm 118 repräsentiert die Schalterstellung des ersten Schaltelements 22 in der bevorzugten Testsequenz 106, das mittlere Diagramm 120 repräsentiert die Schalterstellung des zweiten Schaltelements 24 innerhalb der bevorzugten Testsequenz 106 und das untere Diagramm 122 repräsentiert die Schalterstellung des dritten Schaltelements 48 innerhalb der bevorzugten Testsequenz 106.

Zunächst folgt zu Beginn der Testsequenz ein Funktionstest 108, der hier in zwei Abschnitten 108a, 108b durchgeführt wird. Im ersten Abschnitt 108a wird das zweite Schaltelement 24 betätigt, während das erste Schaltelement 22 und das dritte Schaltelement 48 nicht betätigt sind. Gleichzeitig wird am zweiten Rücklesepunkt 44 ein Rücklesesignal abgegriffen und mit einem Erwartungswert verglichen. Entspricht das im ersten Abschnitt 108a zurückgelesene Signal nicht einer entsprechenden Erwartungshaltung, wird unmittelbar mit dem ersten Schalttest 110 fortgefahren, d.h. der hier dargestellte zweite Abschnitt 108b wird übersprungen. Entspricht hingegen das Rücklesesignal der definierten Erwartungshaltung, wird im selben Programmzyklus, oder alternativ im nachfolgenden Programmzyklus, der zweite Abschnitt 108b des Funktionstests 108 ausgeführt.

Im zweiten Abschnitt 108b wird das erste Schaltelement 22 betätigt, während das zweite Schaltelement 24 und das dritte Schaltelement 48 nicht betätigt sind. Gleichzeitig wird am ersten Rücklesepunkt 42 ein Rücklesesignal abgegriffen und mit einer definierten Erwartungshaltung verglichen. Entspricht das zurückgelesene Signal der Erwartungshaltung, wird die Testsequenz 106 beendet und im nächsten Zyklus mit einem neuen Funktionstest 108 begonnen. Mit anderen Worten wird von der Testeinrichtung 38 solange nur ein Funktionstest 108 durchgeführt, bis beim Funktionstest 108 ein Fehler erkannt wird, welcher in nachfolgenden Schalttests 110, 114 näher bestimmt wird.

Wenn das Rücklesesignal im ersten oder zweiten Abschnitt 108a, 108b nicht der definierten Erwartungshaltung entspricht, wird somit nach dem Funktionstest 108 unmittelbar ein erster Schalttest 110 durchgeführt. Beim ersten Schalttest 110 werden in diesem bevorzugten Ausführungsbeispiel alle möglichen Kombinationen an Schalterstellungen des ersten und zweiten Schaltelements 22, 24 getestet. Das dritte Schaltelement 48 ist dabei nur betätigt, wenn das erste und das zweite Schaltelement 22, 24 betätigt sind. Im Übrigen ist das dritte Schaltelement 48 nicht betätigt. Am Ende der ersten Testperiode 76 wird ein Testmuster 86 aus den in den einzelnen Intervallen der ersten Testperiode 76 aufgenommenen Rücklesesignalen erstellt und mit einem ersten Satz an Fehlermustern 104 verglichen, um einen Fehler zu bestimmen.

Falls sich das nach der ersten Testperiode 76 erzeugte erste Testmuster 86 weder einem Fehler noch einem "Gutfall" eindeutig zuordnen lässt, wird unmittelbar ein zweiter Schalttest 114 durchgeführt.

Wie beim ersten Schalttest 110 werden beim zweiten Schalttest 114 vorzugsweise in vier Testintervallen alle möglichen Kombinationen an Schalterstellungen des ersten und des zweiten Schaltelements 22, 24 getestet, während das dritte Schaltelement 48 während der gesamten zweiten Testperiode 124 betätigt ist. Mit anderen Worten werden beim zweiten Schalttest 114 alle Schalterstellungen des ersten und zweiten Schaltelements vollständig permutiert, während der interne Verbraucher 46 ständig zugeschaltet ist.

Nach der zweiten Testperiode 124 wird ein zweites Testmuster erzeugt und mit einem zweiten Satz an Fehlermustern abgeglichen, um einen Fehler eindeutigen zu bestimmen. Insbesondere lassen sich im zweiten Schalttest 114 Fehler bestimmen, die parallel zu einem Lastbruch auftreten können. So kann beispielsweise bei vorliegen eines Lastbruchs zusätzlich bestimmt werden, ob ein Kurzschluss der Schaltelemente vorliegt. Es können somit weitere Fehler bestimmt werden, die eine bessere Diagnose der Fehlerumstände ermöglicht.

Falls das in der zweiten Testperiode 124 erzeugte zweite Testmuster einem Fehler nicht eindeutig zugeordnet werden kann, liegt ein interner (unbekannter) Defekt der Sicherheitsschaltvorrichtung 10 vor und die Sicherheitsschaltvorrichtung 10 muss in diesem Fall unverzüglich in den Fail-safe-Zustand 116 überführt werden. Vorteilhafterweise tritt dieser Fall erst ein, wenn die bekannten gängigen Fehler ausgeschlossen werden können. Ein "Gutfall" kann in der zweiten Testperiode gemäß dem vorliegenden Ausführungsbeispiels nicht mehr erkannt werden.

Es versteht sich, dass die Testsequenz 106 eine bevorzugte Testsequenz darstellt. In einem bevorzugten Ausführungsbeispiel können einzelne Schalttests je nach Konfiguration ausgelassen oder aber auch nur bestimmte Kombinationen weggelassen werden. Dies hat zwar zur Folge, dass eine Fehlerdiagnose nur noch eingeschränkt möglich ist, erlaubt aber, dass die Sicherheitsschaltvorrichtung auch für externe Verbraucher eingesetzt werden kann, bei denen bestimmte Kombinationen an Schalterstellungen technisch nicht möglich sind. Mit Hilfe der Konfigurationsmöglichkeit lässt sich die neue Sicherheitsschaltvorrichtung somit vorteilhaft für eine Vielzahl von unterschiedlichen externen Verbrauchern 34 verwenden.

Mit Hilfe der bevorzugten Testsequenz 106 können im ersten Schalttest 110 insbesondere die folgenden Fehler erkannt und unterschieden werden: Lastbruch, Kurzschluss der einzelnen Schaltelemente 22, 24, 48 oder Querschluss zum selben Potential, Querschlüsse des ersten und des zweiten Schaltelements zu einem anderen Potential, Unterbrechung eines Schaltelements 22, 24, 48 und ein Kurzschluss des externen Verbrauchers 34 bzw. eine Überlast des externen Verbrauchers 34.

Zusätzlich können durch den zweiten Schalttest 114 im Falle eines Lastbruchs die anderen vorstehend genannten Fehler, also insbesondere Kurz- und Querschlüsse, erkannt werden. Vorteilhafterweise kann ein erkannter Fehler zur weiteren Verarbeitung an das Steuerprogramm gemeldet werden. Beispielsweise kann im Falle eines Lastbruchs ein Bit im PAE gesetzt werden, welches von dem Steuerprogramm in nächsten Programmzyklus berücksichtigt wird.

Mit den neuen Schalttests lassen sich neben dem Lastbruch auch alle anderen gängigen Fehler eindeutig erkennen und somit auch die Unterscheidung treffen, ob ein interner oder externer Fehler vorliegt. Dies ist insbesondere für die Verfügbarkeit der Sicherheitsschaltvorrichtung 10 von Bedeutung, da externe Fehler grundsätzlich behebbar sind und kein Fail-safe-Zustand der Sicherheitsschaltvorrichtung 10 eingenommen werden muss. Weiterhin können parallel zum Lastbruch auch alle anderen Fehler erkannt werden. Zum Beispiel kann im Lastbruchfall zusätzlich ein Querschluss der Ausgänge erkannt werden.

Durch das neue Verfahren werden Fehler wie Querschlüsse (externe Fehler), Kurzschlüsse und Unterbrechungen des ersten bzw. des zweiten Schaltelements 22, 24 sowie des angeschlossenen externen Verbrauchers 34 erkannt. Erst wenn kein Fehler eindeutig bestimmt werden kann und auch der "Gutfall" nicht angenommen werden kann, wird ein interner (unbekannter) Fehler diagnostiziert. Die Verfügbarkeit der Sicherheitsschaltvorrichtung kann damit vorteilhaft erhöht werden.

## Patentansprüche

1. Sicherheitsschaltvorrichtung (10) zum fehlersicheren Abschalten eines externen Verbrauchers (34) mit einem ersten Pol (28) und einem zweiten Pol (32) umfassend
eine erste Klemme (26) zum Aufnehmen eines ersten Potentials,
eine zweite Klemme (30) zum Aufnehmen eines zweiten Potentials,
ein erstes Schaltelement (22) zwischen der ersten Klemme (26) und dem ersten Pol (28) des externen Verbrauchers (34),
ein zweites Schaltelement (24) zwischen der zweiten Klemme (30) und dem zweiten Pol (32) des externen Verbrauchers (34),
eine Signalverarbeitungseinheit (14), die dazu ausgebildet ist, über einen Eingang (36) ein Abschaltsignal aufzunehmen und in Abhängigkeit des Abschaltsignals das erste und das zweite Schaltelement (22, 24) zu betätigen,
einen internen Verbraucher (46), sowie
ein drittes Schaltelement (48), das dazu ausgebildet ist, den internen Verbraucher (46) parallel zu dem externen Verbraucher (34) zu schalten,
wobei zwischen dem ersten Schaltelement (22) und dem ersten Pol (28) ein erster Rücklesepunkt (42) angeordnet ist, wobei zwischen dem zweiten Schaltelement (24) und dem zweiten Pol (32) ein zweiter Rücklesepunkt (44) angeordnet ist, wobei zwischen dem dritten Schaltelement (48) und dem internen Verbraucher (46) ein dritter Rücklesepunkt (50) angeordnet ist,
wobei die Signalverarbeitungseinheit (14) eine Testeinrichtung (38) und einen Speicher (52) beinhaltet, in dem ein erster Satz von Fehlermustern (104) hinterlegt ist,
wobei die Testeinrichtung (38) mit dem ersten, zweiten und dritten Rücklesepunkt (42, 44, 50) gekoppelt ist und dazu ausgebildet ist, einen ersten Schalttest (110) mit mindestens drei voneinander zeitlich getrennten Testintervallen (78, 80, 82; 84) durchzuführen,
wobei die Testeinrichtung (38) eingerichtet ist, in jedem Testintervall (78, 80, 82; 84) an dem ersten, zweiten und dritten Rücklesepunkt (42, 44, 50) je ein Rücklesesignal aufzunehmen, um ein erstes Testmuster (86) zu erzeugen,
wobei die Testeinrichtung (38) ferner dazu eingerichtet ist, das erste Testmuster (86) mit dem ersten Satz von Fehlermustern (104) abzugleichen, um einen Fehler (105) zu bestimmen.

2. Sicherheitsschaltvorrichtung nach Anspruch 1, wobei die Testeinrichtung (38) eingerichtet ist, nach jedem der zeitlich voneinander getrennten Testintervall (78, 80, 82; 84) mindestens eine Schalterstellung des ersten, zweiten oder dritten Schaltelements (22, 24, 48) zu variieren.

3. Sicherheitsschaltvorrichtung nach einem der Ansprüche 1 oder 2, wobei jedem Fehlermuster im ersten Satz von Fehlermustern (104) eindeutig eine Fehlerart zugeordnet ist.

4. Sicherheitsschaltvorrichtung nach einem der Ansprüche 1 bis 3, wobei das erste Testmuster (86) ein Bitfeld (102) ist.

5. Sicherheitsschaltvorrichtung nach einem der Ansprüche 1 bis 4, wobei die Testeinrichtung (38) dazu ausgebildet ist, das erste Testmuster (86) mit einem weiteren Satz von Mustern abzugleichen, um einen fehlerfreien Betrieb zu bestimmen.

6. Sicherheitsschaltvorrichtung nach einem der Ansprüche 1 bis 5, wobei der erste Schalttest (110) vier voneinander getrennte Testintervalle (78, 80, 82, 84) beinhaltet.

7. Sicherheitsschaltvorrichtung nach einem der Ansprüche 1 bis 6, wobei die Testeinrichtung (38) eingerichtet ist, für den ersten Schalttest (110) in einem ersten Intervall (78) weder das erste noch das zweite Schaltelemente (22, 24) zu betätigen, in einem zweiten Intervall (80) nur das erste Schaltelement (22) zu betätigen, in einem dritten Intervall (84) nur das zweite Schaltelement (24) zu betätigen und in einem vierten Intervall (82) das erste und das zweite Schaltelement (22, 24) zu betätigen, insbesondere wobei nur im vierten Intervall (82) das dritte Schaltelement (48) betätigt ist.

8. Sicherheitsschaltvorrichtung nach einem der Ansprüche 1 bis 7, wobei die Testeinrichtung (38) dazu ausgebildet ist, ein Fehlersignal, welches die Fehlerart repräsentiert, anhand des ersten Schaltests (110) auszugeben, wenn durch den ersten Schalttest (110) ein Fehler eindeutig bestimmt ist.

9. Sicherheitsschaltvorrichtung nach einem der Ansprüche 1 bis 8, wobei der erste Schalttest (110) hinsichtlich der Anzahl der voneinander zeitlich getrennten Testintervalle (78, 80, 82; 84) konfigurierbar ist.

10. Sicherheitsschaltvorrichtung nach einem der Ansprüche 1 bis 9, wobei die Testeinrichtung (38) dazu ausgebildet ist, einen Funktionstest (108) durchzuführen, der dem ersten Schalttest (110) vorgeschaltet ist, insbesondere wobei die Testeinrichtung (38) eingerichtet ist, für den Funktionstest (108) nacheinander das erste Schaltelement (22) und das zweite Schaltelement (24) zu betätigen und beim Betätigen des ersten Schaltelements (22) durch Rücklesen am ersten Rücklesepunkt (42) die Funktionsfähigkeit des ersten Schaltelements (22) zu bestimmen, und beim Betätigen des zweiten Schaltelements (24) durch Rücklesen am zweiten Rücklesepunkt (44) die Funktionsfähigkeit des zweiten Schaltelements (24) zu bestimmen.

11. Sicherheitsschaltvorrichtung nach Anspruch 10, wobei die Testeinrichtung (38) dazu eingerichtet ist, den ersten Schalttest (110) nur dann durchzuführen, wenn in dem Funktionstest (108) ein Fehler bestimmt worden ist.

12. Sicherheitsschaltvorrichtung nach einem der Ansprüche 1 bis 11, wobei die Testeinrichtung (38) eingerichtet ist, nach dem ersten Schalttest (110) einen zweiten Schalttest (114) durchzuführen, um ein zweites Testmuster zu erzeugen, wenn nach dem ersten Schalttest (110) kein Fehler eindeutig bestimmt ist, insbesondere wobei die Testeinrichtung (38) eingerichtet ist, für den zweiten Schalttest (114) in einem ersten Intervall weder das erste noch das zweite Schaltelemente (22, 24) zu betätigen, in einem zweiten Intervall nur das erste Schaltelement (22) zu betätigen, in einem dritten Intervall nur das zweite Schaltelement (24) zu betätigen und in einem vierten Intervall das erste und das zweite Schaltelement (22, 24) zu betätigen, wobei in dem ersten, zweiten, dritten und vierten Intervall das dritte Schaltelement (48) betätigt ist.

13. Sicherheitsschaltvorrichtung nach Anspruch 12, wobei in dem Speicher (52) ein zweiter Satz von Fehlermustern hinterlegt ist und die Testeinrichtung (38) dazu eingerichtet ist, das zweite Testmuster mit dem zweiten Satz von Fehlermustern abzugleichen, um einen Fehler eindeutig zu bestimmen.

14. Sicherheitsschaltvorrichtung nach einem der Ansprüche 12 oder 13, wobei die Testeinrichtung (38) dazu ausgebildet ist, ein Fehlersignal, welches die Fehlerart repräsentiert, anhand des zweiten Schalttests (114) auszugeben, wenn durch den ersten Schalttest (110) kein Fehler eindeutig bestimmt ist, insbesondere wobei die Fehlerart einen internen Hardwarefehler repräsentiert, wenn durch den zweiten Schalttest (114) kein Fehler eindeutig bestimmt ist.

15. Verfahren zum fehlersicheren Abschalten eines externen Verbrauchers (34) mit einem ersten Pol (28), der über ein erstes Schaltelement (22) mit einer ersten Klemme (26) zum Aufnehmen eines ersten Potentials gekoppelt ist, und mit einem zweiten Pol (32), der über ein zweites Schaltelement (24) mit einer zweiten Klemme (30) zum Aufnehmen eines zweiten Potentials gekoppelt ist, das Verfahren umfasst die Schritte:
- Aufnehmen eines Abschaltsignals;
- Betätigen des ersten und des zweiten Schaltelements (22, 24) in Abhängigkeit des Abschaltsignals;
- Bereitstellen eines internen Verbrauchers (46) sowie Bereitstellen eines dritten Schaltelements (48), wobei der interne Verbraucher (46) durch Betätigen des dritten Schaltelements (48) zu dem externen Verbraucher (34) parallel schaltbar ist;
- Bereitstellen eines ersten, zweiten und dritten Rücklesepunkts (42, 44, 50) zwischen dem ersten, zweiten und dritten Schaltelement (22, 24, 48) und dem externen und internen Verbraucher (34, 46);
- Bereitstellen eines ersten Satzes von Fehlermustern (104);
- Durchführen eines ersten Schalttests (110) mit mindestens drei zeitlich voneinander getrennten Testintervallen (78, 80, 82; 84);
- Erzeugen eines ersten Testmusters (86) durch Rücklesen je eines Rücklesesignals an dem ersten, zweiten und dritten Rücklesepunkt (42, 44, 50) in jedem der mindestens drei zeitlich voneinander getrennten Testintervallen (78, 80, 82; 84);
- Bestimmen eines Fehlers (105) durch Abgleichen des ersten Testmusters (86) mit dem ersten Satz von Fehlermustern (104).

## Claims

1. A safety switching device (10) for fail-safe disconnecting an external load (34) that has a first pole (28) and a second pole, (32) comprising:
a first terminal (26) for receiving a first potential,
a second terminal (30) for receiving a second potential,
a first switching element (22) between the first terminal (26) and the first pole (28) of the external load (34),
a second switching element (24) between the second terminal (30) and the second pole (32) of the external load (34),
a signal processing unit (14) configured to receive a switch-off signal via an input (36) and to actuate, based on the switch-off signal, the first and second switching element (22, 24),
an internal load (46), and
a third switching element (48) configured to connect the internal load (46) in parallel with the external load (34),
wherein a first read-back point (42) is arranged between the first switching element (22) and the first pole (28), a second read-back point (44) is arranged between the second switching element (24) and the second pole (32), and a third read-back point (50) is arranged between the third switching element (48) and the internal load (46),
wherein the signal processing unit (14) includes a testing device (38) and a memory (52) in which a first set of error patterns (104) is stored,
wherein the testing device (38) is connected to the first, second and third read-back point (42, 44, 50) and is configured to perform a first switching test (110) having at least three test intervals (78, 80, 82; 84) separated in time,
wherein the testing device (38) is configured to receive a read-back signal in each test interval (78, 80, 82; 84) at the first, second and third read-back point (42, 44, 50) to generate a first test pattern (86),
wherein the testing device (38) is further configured to match the first test pattern (86) with the first set of error patterns (104) to determine an error (105).

2. The safety switching device according to claim 1, wherein the testing device (38) is configured to vary at least one switch position of the first, second or third switching element (22, 24, 48) after each of the test intervals (78, 80, 82; 84) which are separated in time.

3. The safety switching device according to claim 1 or 2, wherein each error pattern in the first set of error patterns (104) is uniquely assigned a fault type.

4. The safety switching device according to any one of claims 1 to 3, wherein the first test pattern (86) is a bit field (102).

5. The safety switching device according to any one of claims 1 to 4, wherein the testing device (38) is configured to match the first test pattern (86) with a further set of patterns to determine fault-free operation.

6. The safety switching device according to any one of claims 1 to 5, wherein the first switching test (110) includes four separate test intervals (78, 80, 82, 84).

7. The safety switching device according to any one of claims 1 to 6, wherein the testing device (38) is configured to actuate, for the first switching test (110), neither the first nor the second switching element (22, 24) in a first interval (78), only the first switching element (22) in a second interval (80), only the second switching element (24) in a third interval (84), and the first and the second switching element (22, 24) in a fourth interval (82), in particular wherein the third switching element (48) is actuated only in the fourth interval (82).

8. The safety switching device according to any one of claims 1 to 7, wherein the testing device (38) is configured to output an error signal representing the type of error based on the first switching test (110) if an error is determined by the first switching test (110) unambiguously.

9. The safety switching device according to any one of claims 1 to 8, wherein the first switching test (110) is configurable with respect to the number of test intervals (78, 80, 82; 84) separated in time.

10. The safety switching device according to any one of claims 1 to 9, wherein the testing device (38) is configured to perform a functional test (108) preceding the first switching test (110), in particular wherein the testing device (38) is configured, for the functional test (108), to actuate the first switching element (22) and the second switching element (24) in succession and, when actuating the first switching element (22), to determine the functional capability of the first switching element (22) by reading back the first read-back point (42), and, when actuating the second switching element (24), to determine the functional capability of the second switching element (24) by reading back the second read-back point (44).

11. The safety switching device according to claim 10, wherein the testing device (38) is configured to perform the first switching test (110) only if an error has been determined in the functional test (108).

12. The safety switching device according to any one of claims 1 to 11, wherein the testing device (38) is configured to perform a second switching test (114) after the first switching test (110) in order to generate a second test pattern if after the first switching test (110) no error is determined unambiguously, in particular wherein the testing device (38) is configured, for the second switching test (114), to actuate neither the first nor the second switching element (22, 24) in a first interval, only the first switching element (22) in a second interval, only the second switching element (24) in a third interval, and the first and the second switching element (22, 24) in a fourth interval, wherein in the first, second, third and fourth interval the third switching element (48) is actuated.

13. The safety switching device according to claim 12, wherein a second set of error patterns is stored in the memory (52) and the testing device (38) is configured to compare the second test pattern with the second set of error patterns in order to unambiguously determine an error.

14. The safety switching device according to claim 12 or 13, wherein the testing device (38) is configured to output an error signal representing the type of error based on the second switching test (114) if no error is unambiguously determined by the first switching test (110), in particular wherein the type of error represents an internal hardware error if no error is unambiguously determined by the second switching test (114).

15. A method for fail-safe disconnecting an external load (34) that has a first pole (28) connected via a first switching element (22) to a first terminal (26) for receiving a first potential, and a second pole (32) connected via a second switching element (24) to a second terminal (30) for receiving a second potential, the method comprising:
- Receiving a switch-off signal;
- Actuating the first and second switching element (22, 24) based on the switch-off signal;
- Providing an internal load (46) and a third switching element (48), wherein the internal load (46) is connectable in parallel with the external load (34) by actuating the third switching element (48);
- Providing a first, a second and a third read-back point (42, 44, 50) between the first, second and third switching element (22, 24, 48) and the external and internal loads (34, 46);
- Providing a first set of error patterns (104);
- Performing a first switching test (110) with at least three test intervals (78, 80, 82; 84) separated in time;
- Generating a first test pattern (86) by reading back a read-back signal at each of the first, second and third read-back point (42, 44, 50) in each of the at least three test intervals (78, 80, 82; 84) separated in time;
- Determining an error (105) by matching the first test pattern (86) with the first set of error patterns (104).

## Revendications

1. Dispositif de commutation de sécurité (10) destiné à désactiver en toute sécurité un consommateur extérieur (34) pourvu d'un premier pôle (28) et d'un deuxième pôle (32), ledit dispositif comprenant
une première borne (26) destinée à recevoir un premier potentiel,
une deuxième borne (30) destinée à recevoir un deuxième potentiel,
un premier élément de commutation (22) placé entre la première borne (26) et le premier pôle (28) du consommateur extérieur (34),
un deuxième élément de commutation (24) placé entre la deuxième borne (30) et le deuxième pôle (32) du consommateur extérieur (34),
une unité de traitement de signal (14) qui est conçue pour recevoir un signal de désactivation par le biais d'une entrée (36) et pour actionner les premier et deuxième éléments de commutation (22, 24) en fonction du signal de désactivation,
un consommateur intérieur (46), et
un troisième élément de commutation (48) qui est conçu pour connecter le consommateur intérieur (46) en parallèle au consommateur extérieur (34),
un premier point de relecture (42) étant disposé entre le premier élément de commutation (22) et le premier pôle (28), un deuxième point de relecture (44) étant disposé entre le deuxième élément de commutation (24) et le deuxième pôle (32), un troisième point de relecture (50) étant disposé entre le troisième élément de commutation (48) et le consommateur intérieur (46),
l'unité de traitement de signal (14) comprenant un moyen de test (38) et une mémoire (52) dans laquelle un premier ensemble de modèles d'erreur (104) est stocké,
le moyen de test (38) étant accouplé aux premier, deuxième et troisième points de relecture (42, 44, 50) et étant conçu pour effectuer un premier test de commutation (110) avec au moins trois intervalles de test (78, 80, 82 ; 84) espacés temporellement les uns des autres,
le moyen de test (38) étant conçu pour recevoir un signal de relecture dans chaque intervalle de test (78, 80, 82 ; 84) aux premier, deuxième et troisième points de relecture (42, 44, 50) afin de générer un premier modèle de test (86),
le moyen de test (38) étant en outre conçu pour comparer le premier modèle de test (86) avec le premier ensemble de modèles d'erreur (104) pour déterminer une erreur (105).

2. Dispositif de commutation de sécurité selon la revendication 1, le moyen de test (38) étant conçu pour faire varier au moins une position de commutation du premier, deuxième ou troisième élément de commutation (22, 24, 48) après chacun des intervalles de test (78, 80, 82 ; 84) espacés temporellement les uns des autres.

3. Dispositif de commutation de sécurité selon l'une des revendications 1 ou 2, chaque modèle d'erreur du premier ensemble de modèles d'erreur (104) étant associé de façon univoque à un type d'erreur.

4. Dispositif de commutation de sécurité selon l'une des revendications 1 à 3, le premier modèle de test (86) étant un champ de bits (102).

5. Dispositif de commutation de sécurité selon l'une des revendications 1 à 4, le moyen de test (38) étant conçu pour comparer le premier modèle de test (86) avec un autre ensemble de modèles afin de déterminer un fonctionnement sans erreur.

6. Dispositif de commutation de sécurité selon l'une des revendications 1 à 5, le premier test de commutation (110) contenant quatre intervalles de test (78, 80, 82, 84) séparés les uns des autres.

7. Dispositif de commutation de sécurité selon l'une des revendications 1 à 6, le moyen de test (38) étant conçu pour actionner ni le premier ni le deuxième élément de commutation (22, 24) pour le premier test de commutation (110) dans un premier intervalle (78), et pour actionner uniquement le premier élément de commutation (22) dans un deuxième intervalle (80), pour actionner uniquement le deuxième élément de commutation (24) dans un troisième intervalle (84) et pour actionner les premier et deuxième éléments de commutation (22, 24) dans un quatrième intervalle (82), en particulier le troisième élément de commutation (48) étant actionné uniquement dans le quatrième intervalle (82).

8. Dispositif de commutation de sécurité selon l'une des revendications 1 à 7, le moyen de test (38) étant conçu pour délivrer un signal d'erreur, qui représente le type d'erreur, sur la base du premier test de commutation (110) si une erreur est déterminée de façon univoque par le premier test de commutation (110).

9. Dispositif de commutation de sécurité selon l'une des revendications 1 à 8, le premier test de commutation (110) étant configurable en fonction du nombre d'intervalles de test (78, 80, 82 ; 84) espacés temporellement les uns des autres.

10. Dispositif de commutation de sécurité selon l'une des revendications 1 à 9, le moyen de test (38) étant conçu pour effectuer un test de fonctionnement (108) qui précède le premier test de commutation (110), en particulier le moyen de test (38) étant conçu pour actionner le premier élément de commutation (22) et le deuxième élément de commutation (24) successivement pour le test de fonctionnement (108) et, lorsque le premier élément de commutation (22) est actionné, pour déterminer la fonctionnalité du premier élément de commutation (22) par relecture au premier point de relecture (42) et, lorsque le deuxième élément de commutation (24) est actionné, pour déterminer la fonctionnalité du deuxième élément de commutation (24) par relecture au deuxième point de relecture (44).

11. Dispositif de commutation de sécurité selon la revendication 10, le moyen de test (38) étant conçu pour effectuer le premier test de commutation (110) uniquement si une erreur a été déterminée dans le test de fonctionnement (108).

12. Dispositif de commutation de sécurité selon l'une des revendications 1 à 11, le moyen de test (38) étant conçu pour effectuer un deuxième test de commutation (114) après le premier test de commutation (110) afin de générer un deuxième modèle de test si, après le premier test de commutation (110), aucune erreur n'est déterminée de façon univoque, en particulier le moyen de test (38) étant conçu pour actionner ni le premier ni le deuxième élément de commutation (22, 24) pour le deuxième test de commutation (114) dans un premier intervalle, pour actionner uniquement le premier élément de commutation (22) dans un deuxième intervalle, pour actionner uniquement le deuxième élément de commutation (24) dans un troisième intervalle et pour actionner les premier et deuxième éléments de commutation (22, 24) dans un quatrième intervalle, le troisième élément de commutation (48) étant actionné dans les premier, deuxième, troisième et quatrième intervalles.

13. Dispositif de commutation de sécurité selon la revendication 12, un deuxième ensemble de modèles d'erreur étant stocké dans la mémoire (52) et le moyen de test (38) étant conçu pour comparer le deuxième modèle de test avec le deuxième ensemble de modèles d'erreur afin de déterminer une erreur de façon univoque.

14. Dispositif de commutation de sécurité selon l'une des revendications 12 ou 13, le moyen de test (38) étant conçu pour délivrer un signal d'erreur, qui représente le type d'erreur, sur la base du deuxième test de commutation (114) si aucune erreur n'est déterminée de façon univoque par le premier test de commutation (110), en particulier le type d'erreur représentant une erreur matérielle interne si aucune erreur n'est déterminée de façon univoque par le deuxième test de commutation (114).

15. Procédé de désactivation en toute sécurité d'un consommateur extérieur (34) pourvu d'un premier pôle (28), qui est accouplé par le biais d'un premier élément de commutation (22) à une première borne (26) pour recevoir un premier potentiel, et d'un deuxième pôle (32) qui est accouplé par le biais d'un deuxième élément de commutation (24) à une deuxième borne (30) pour recevoir un deuxième potentiel, le procédé comprenant les étapes suivantes :
- recevoir un signal de désactivation ;
- actionner le premier et le deuxième élément de commutation (22, 24) en fonction du signal de désactivation ;
- fournir un consommateur intérieur (46) et fournir un troisième élément de commutation (48), le consommateur intérieur (46) pouvant être connecté en parallèle au consommateur extérieur (34) par actionnement du troisième élément de commutation (48) ;
- fournir un premier, un deuxième et un troisième point de relecture (42, 44, 50) entre le premier, le deuxième et le troisième élément de commutation (22, 24, 48) et les consommateurs extérieur et intérieur (34, 46) ;
- fournir un premier ensemble de modèles d'erreur (104) ;
- effectuer un premier test de commutation (110) avec au moins trois intervalles de test (78, 80, 82 ; 84) espacés temporellement les uns des autres ;
- générer un premier modèle de test (86) par relecture d'un signal de relecture respectivement aux premier, deuxième et troisième points de lecture (42, 44, 50) dans chacun des au moins trois intervalles de test (78, 80, 82 ; 84) espacés temporellement les uns des autres ;
- déterminer une erreur (105) par comparaison du premier modèle de test (86) avec le premier ensemble de modèles d'erreur (104).
